# FASCICULE DE BREVET EUROPEEN

(11) **EP 0 606 805 B1**
(45) Date de publication et mention de la délivrance du brevet: **12.03.1997**
(21) Numéro de dépôt: 93403186.5
(22) Date de dépôt: 27.12.1993
(51) Int. Cl.: H01L 21/66, G01R 31/28

(54) **Procédé de test de puces de circuit intégré et dispositif intégré correspondant**
Testverfahren für Elemente von integrierten Schaltungen und dazugehöriges integriertes Element
Test method for integrated circuit devices and related integrated device

(30) Priorité: 31.12.1992 FR 9215997
(43) Date de publication de la demande: 20.07.1994
(73) Titulaire: SGS-THOMSON MICROELECTRONICS S.A., 94250 Gentilly (FR)
(72) Inventeur: Tailliet, Francois, F-75116 Paris (FR)
(74) Mandataire: Ballot, Paul Denis Jacques

(56) Documents cités:
- FR-A- 2 203 977
- US-A- 4 038 648
- US-A- 4 956 602
- PROCEEDINGS OF THE INTERNATIONAL TEST CONFERENCE, WASHINGTON D.C. USA, IEEE, 1 Septembre 1987 pages 451 - 457 H. W. TROMBLEY ET AL
- PROCEEDINGS OF THE 1990 INTERNAT. CONF. ON MICROELECTRONIC TEST STRUCTURES, SAN DIEGO USA, IEEE, 5 Mars 1990 pages 75 - 80 A. J. WALTON ET AL

## Description

L'invention concerne la réalisation des circuits intégrés et elle vise à proposer à la fois un procédé de test original et une construction de tranche de circuit intégré permettant de mettre en oeuvre ce test.

Les puces de circuits intégrés, qui font ordinairement quelques millimètres de côté, sont réalisées en série sur des tranches semiconductrices de plusieurs centimètres à plusieurs dizaines de centimètres de diamètre. Plusieurs dizaines, centaines, ou milliers de puces sont donc fabriquées à la fois sur une même tranche, et la tranche est découpée en puces individuelles en fin de fabrication. Puis ces puces sont mises dans des boîtiers de protection appropriés.

Une phase essentielle de la fabrication est le test sur tranche de toutes les puces; ce test permet de rejeter les puces mauvaises avant leur encapsulation, ce qui évite de grever les coûts de fabrication par l'encapsulation inutile et coûteuse de puces mauvaises.

Le test sur tranche est effectué à l'aide d'un appareil de test qui est muni d'un ensemble de pointes extrêmement fines, que l'on vient appliquer contre les plots d'entrée/sortie de chaque puce. Ces plots sont les plots de contact qui serviront ultérieurement à permettre la communication de la puce avec l'extérieur.

L'appareil de test est donc conçu pour appliquer avec précision les pointes de test sur les plots de contact d'une puce, effectuer le test de cette puce, marquer la puce si elle est mauvaise, déplacer les pointes sur la puce suivante, effectuer le test, etc.

Cette procédure est longue puisqu'elle est répétée autant de fois qu'il y a de puces. En général, si la puce est simple la procédure de test peut être simple, mais alors il y a beaucoup de puces (plusieurs milliers) par tranche; et si la puce est complexe il y a moins de puces par tranche (plusieurs centaines) mais la procédure de test de chaque puce est plus longue. Dans les deux cas, le temps de test d'une tranche peut être très long, de sorte que le test devient le principal facteur de coût des circuits intégrés. L'appareil de test est en effet très coûteux et le nombre d'appareils de test qu'il faut prévoir pour assurer une fabrication de circuits intégrés en série est d'autant plus élevé que les temps de test de tranches sont plus grands.

On peut imaginer de tester toutes les puces d'une tranche en parallèle puisque les procédures à effectuer sur chaque puce sont identiques. Mais cela supposerait de réaliser un appareil ayant un nombre de pointes de test égal au produit du nombre de puces par le nombre de plots de contact de chaque puce. A titre d'exemple, pour une tranche de 1000 puces de 8 contacts chacune, il faudrait 8000 pointes de test pour l'appareil, au lieu de 8 pointes. L'appareil serait tellement coûteux qu'on perdrait tout l'avantage financier qu'apporterait la réduction du temps de test de la tranche. De plus, il serait difficile de séparer les signaux renvoyés par les différentes puces en réponse aux signaux envoyés par l'appareil de test, de sorte qu'on aurait du mal à repérer les puces défectueuses.

Par ailleurs, on connaît une méthode de test sur tranche, décrite dans le document US-A-4 956 602 correspondant aux caractéristiques précisées dans la première partie des revendications 1 et 2, qui évite de déplacer les pointes de test sur chaque cellule à tester. Un seul groupe de plots de test est prévu sur la tranche et est relié par un démultiplexeur à toutes les puces à tester.

Des bus sont placés sur les chemins de découpe entre les puces pour relier les puces au démultiplexeur.

Cependant, cette méthode nécessite de tester chaque puce successivement et par conséquent, ne permet pas un gain de temps important.

C'est pourquoi on propose selon l'invention une autre approche du test sur tranche permettant d'effectuer certaines tâches du test en parallèle sur toutes les puces.

Selon l'invention telle que définie dans la revendication 1, on propose une tranche de circuit intégré destinée à être découpée en puces individuelles, comprenant à cet effet des zones principales comportant chacune un circuit intégré respectif qui formera une puce respective après découpe de la tranche, les zones principales étant séparées les unes des autres par des zones de découpe le long desquelles seront effectuées les découpes entre puces individuelles, la tranche comportant un démultiplexeur et des plots de contact situés dans une zone de circuit de test située en dehors des zones principales, le démultiplexeur ayant des entrées de signaux de test et des entrées de commande reliées aux plots de contact et ayant des sorties reliées à des bus de conducteurs qui passent le long des zones de découpe entre puces et qui peuvent être reliés aux circuits intégrés des zones principales, caractérisée en ce qu'elle comporte des moyens pour relier simultanément un plot de contact de chaque puce, destiné à recevoir une tension d'alimentation, à un conducteur de la tension d'alimentation, même si toutes les puces ne sont pas sélectionnées par le démultiplexeur.

L'invention propose aussi un procédé de test tel que défini dans la revendication 4.

De préférence, pour éviter d'avoir un nombre de bus de sortie égal aux nombre de puces, ce qui formerait un réseau très encombrant entre les lignes et colonnes de puces, on prévoit qu'il y a autant de bus de sorties que de lignes de puces dans la tranche; on prévoit également un connecteur local, à proximité de chaque puce, entre la puce et un bus qui passe à côté d'elle, et on prévoit des conducteurs de colonne, passant entre les colonnes de puces, chaque conducteur de colonne permettant de commander simultanément tous les connecteurs locaux correspondant aux puces de cette colonne. Les conducteurs de colonne sont reliés aux sorties d'un décodeur de colonne ayant ses entrées reliées à des plots de contact de la zone de circuit de test, de sorte qu'un conducteur de colonne déterminé peut être sélectionné par l'appareil de test.

On peut ainsi sélectionner par l'appareil à la fois un bus en ligne (sélection par le démultiplexeur) et un conducteur en colonne (sélection par le décodeur), afin de tester une puce déterminée située au croisement de cette ligne et de cette colonne.

Cette approche du test sur tranche selon l'invention, permet d'effectuer en parallèle sur toutes les puces certaines tâches qui peuvent être effectuées simultanément, tout en conservant un traitement successif des tâches qui ne peuvent être effectuées que puce par puce. On aboutit donc à une réduction notable du temps de test global et donc du coût résultant, et ceci sans exiger un appareil de test très coûteux ou impossible à réaliser.

Le démultiplexeur agit comme démultiplexeur pour l'envoi de stimuli de test vers une puce, mais il agit aussi comme multiplexeur pour recueillir de cette puce des réponses à ces stimuli.

Les circuits intégrés des zones principales sont pourvus de plots de contact qui serviront ultérieurement à la connexion de la puce avec l'extérieur; de préférence, les bus issus du démultiplexeur sont reliés à ces plots de contact par l'intermédiaire du connecteur local situé à proximité de chaque puce.

D'autres caractéristiques et avantages de l'invention apparaîtront à la lecture de la description détaillée qui suit et qui est faite en référence aux dessins annexés dans lesquels :
- la figure 1 représente une tranche de circuit intégré classique comportant de multiples puces;
- la figure 2 représente schématiquement l'organisation générale d'une tranche selon l'invention;
- la figure 3 représente schématiquement la zone de circuit de test prévue sur la tranche pour les opérations de test;
- la figure 4 représente la connexion locale entre un bus de test et une puce à tester.

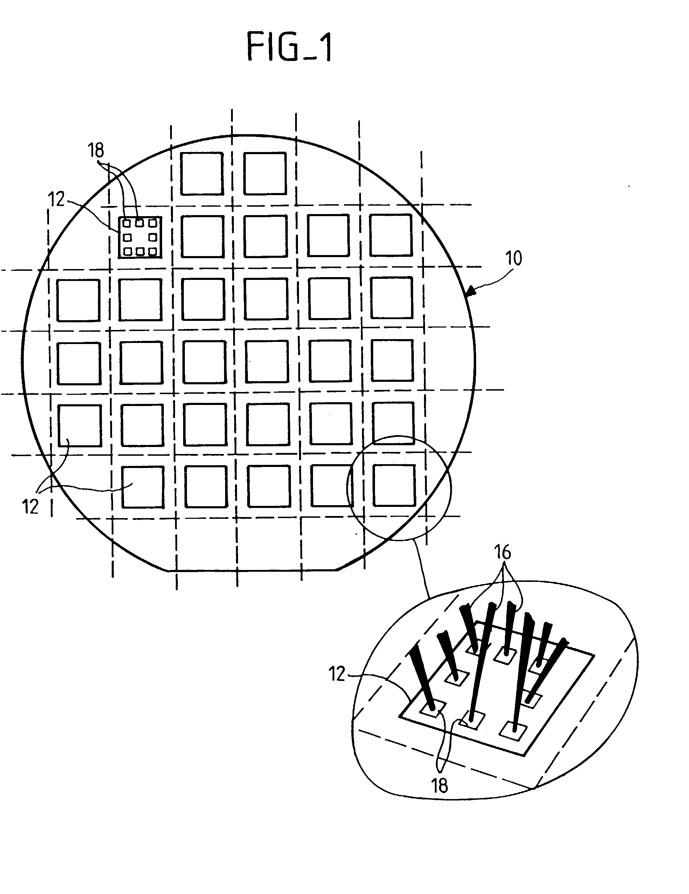

Sur la figure 1 on a représenté une tranche de circuit intégré classique 10 sur laquelle ont été réalisés de multiples circuits intégrés identiques 12 disposés en réseau de lignes et colonnes de circuits. La tranche est destinée être découpée selon des lignes horizontales et verticales (traits tiretés) s'étendant entre les lignes et colonnes de circuits; cette découpe sépare les circuits les uns des autres en puces rectangulaires individuelles comportant chacune un circuit intégré respectif.

Les circuits intégrés sont testés individuellement avant la découpe en puces, dans une opération appelée "test sur tranche" par opposition au test du circuit en boîtier.

Le test est le même pour toutes les puces. Par exemple, pour une mémoire, le test consiste à appliquer des signaux d'adresse et des signaux de données à enregistrer, puis à lire les données effectivement enregistrées.

Le test est effectué par un testeur qui se compose d'une partie mécanique et d'une partie électrique.

La partie mécanique comprend :
- une table mobile X-Y à déplacement micrométrique, portant la tranche 10 à tester,
- un systèmes de pointes 16 qui peuvent venir se poser simultanément sur les différents plots de contact 18 d'une puce,
- un système d'alignement précis pour positionner les pointes sur une puce et pour déplacer la table X-Y pas-à-pas de manière à passer à une autre puce d'une ligne ou colonne voisine quand le test de la première puce est fini;
- un système d'encrage pour marquer la puce testée si elle s'avère défectueuse.

La partie électrique du testeur comprend le système de pilotage de la table X-Y, et un ordinateur qui envoie les séquences de test aux puces à travers les pointes de test, et qui analyse les signaux reçus en retour du circuit testé.

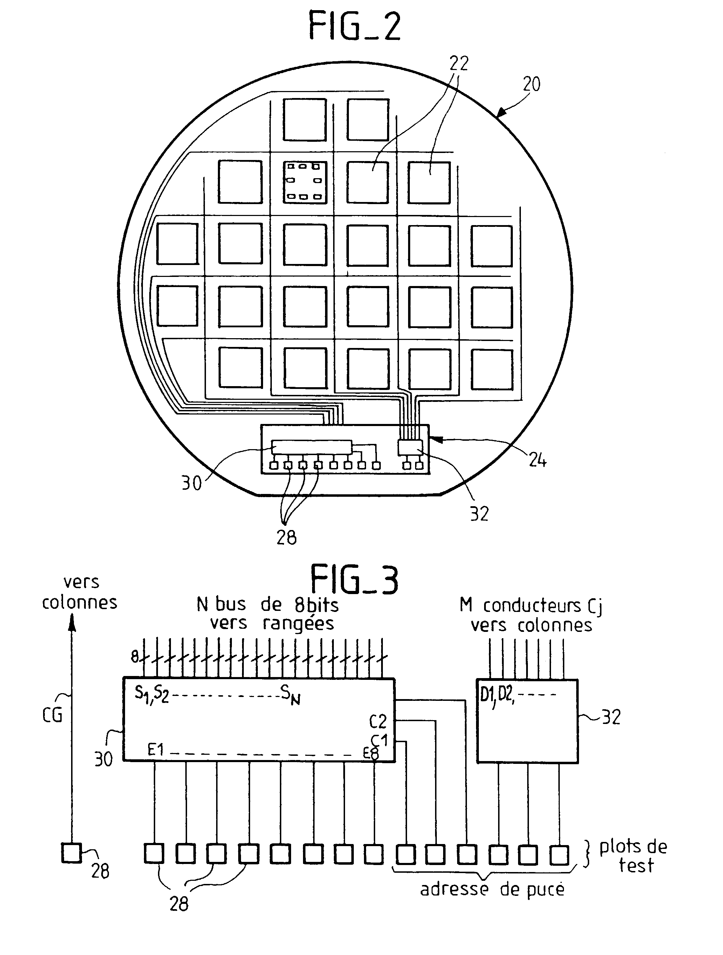

La figure 2 représente schématiquement une tranche 20 selon l'invention : un réseau de N lignes et M colonnes de circuits intégrés 22 est prévu comme à la figure 1; la tranche est destinée à être ultérieurement découpée en puces individuelles comportant chacune un circuit 22 respectif.

Une zone spécifique 24 de la tranche, en dehors des circuits 22, comporte un circuit intégré servant uniquement au test.

Ce circuit spécifique de test comprend dans sa version la plus simple :
- des plots de contact 28 qui ne servent que pendant le test et contre lesquels peuvent venir s'appliquer les pointes de l'appareil de test,
- et un démultiplexeur 30 ayant des entrées de signaux et des entrées de commande reliées aux plots de contact et des sorties reliées à un grand nombre de bus de plusieurs conducteurs chacun.

Les bus partent des sorties du démultiplexeur et s'étendent le long des lignes de découpe future de la puce (lignes horizontales et verticales représentées à la figure 1), pour passer le long de toutes les puces qu'on veut pouvoir tester. Les bus servent à accéder individuellement à chaque puce en fonction des commandes appliquées au démultiplexeur 30 par l'appareil de test. Il pourrait y avoir un bus par puce, mais, dans le cas où les puces sont très nombreuses on préfère avoir par exemple un bus pour toute une rangée de puces, et autant de bus que de rangées, la sélection d'une puce à l'intérieur d'une rangée étant faite par un autre moyen; ce moyen peut être un décodeur de colonne 32, ayant des entrées d'adressage reliées à des plots 28, et des sorties qui sont reliées à des conducteurs de colonne s'étendant entre les colonnes de puces pour sélectionner une colonne de puces parmi les autres.

L'appareil de test, relié par des pointes aux plots 28, va donc pouvoir commander le démultiplexeur 30 et le décodeur 32 pour sélectionner une puce unique, lui appliquer des signaux de test par un bus qui permet de relier la puce au démultiplexeur, et recueillir par ce bus des signaux en retour, pour les transmettre à l'appareil de test.

On peut alors successivement tester chaque puce sans avoir à déplacer mécaniquement les pointes de test.

Mais de plus, cette configuration du système de test permet d'accélérer encore le test car elle permet de paralléliser certaines opérations de test lorsque ces opérations peuvent être effectuées simultanément pour les différentes puces.

Un exemple simple peut être donné à titre d'illustration dans le cas de puces comportant une mémoire électriquement effaçable et programmable; la procédure de base du test peut se diviser en trois étapes :
A. Protocole d'envoi d'une adresse et d'une donnée; durée 0,3 milliseconde;
B. Cycle de programmation : un automate d'écriture enregistre dans la mémoire, à l'adresse reçue, la donnée reçue; durée : environ 10 millisecondes, majorée à 15 millisecondes pour tenir compte du fait que la durée n'est pas la même pour toutes les puces;
C. Protocole de lecture de la donnée à l'adresse indiquée : 0,4 ms.

La tâche A doit s'effectuer successivement puce par puce, puisqu'il faut envoyer par les bus les adresses et les données alors que le bus ne permet d'accéder qu'à une puce à la fois. On pourrait toutefois imaginer dans certains cas que les bus permettent d'accéder simultanément à toutes les puces pour cette tâche, et que la tâche soit alors parallélisée.

La tâche B peut s'effectuer en parallèle pour toutes les puces à la fois, car elle est effectuée par un automate interne à chaque puce. Pour chaque puce la tâche B peut commencer dès que la tâche A est terminée pour cette puce (mais sans attendre qu'elle soit terminée pour les autres puces).

La tâche C doit nécessairement être effectuée puce par puce car il faut pouvoir distinguer les données lues dans les différentes puces après l'opération d'écriture. La tâche C peut commencer pour une puce après la fin de la tâche B de cette puce, mais à condition cependant que toutes les tâches A soient terminées car on ne peut envoyer par le testeur une donnée à écrire pendant qu'on renvoie au testeur une donnée lue.

Au total, dans cet exemple, le temps total de test pour X puces varie entre :
T1 = X.0,3 ms + 15 ms + 0,4 ms (cas favorable où toutes les tâches A sont terminées alors que la tâche B du premier produit n'est pas terminée)
   et
T2 = X.0,3 ms + X.0,4 ms (cas défavorable où la tâche C du premier produit doit être retardée jusqu'à ce que toutes les tâches A soient terminées).

Pour un nombre de puces de 5000 (classique pour des petits circuits à huit plots de contact sur tranche de 15 cm de diamètre environ), le temps total de test est de 3,5 secondes dans cet exemple. Avec un test sous pointes classique, puce par puce, le temps de test serait de X.(0,3 + 0,4 + 15) ms = 1 minute 18 secondes.

Si la procédure de test comporte 20 étapes d'écriture et lecture de données, le temps de test classique est de 26 minutes; avec l'invention il est de 1mn 10s.

Il faut pouvoir connecter à tout moment n'importe quelle puce aux pointes de test par l'intermédiaire du démultiplexeur et des bus qui partent de ce dernier.

On va décrire à propos d'un exemple comment se fait cette connexion.

On suppose que la tranche non découpée comporte un réseau de puces de N = 100 rangées parallèles de M = 50 puces au maximum chacune (la tranche est ronde et certaines rangées ou colonnes peuvent être incomplètes). On suppose que les puces ont P = 8 contacts extérieurs, ce qui est le cas des puces pour cartes à mémoire de format carte de crédit.

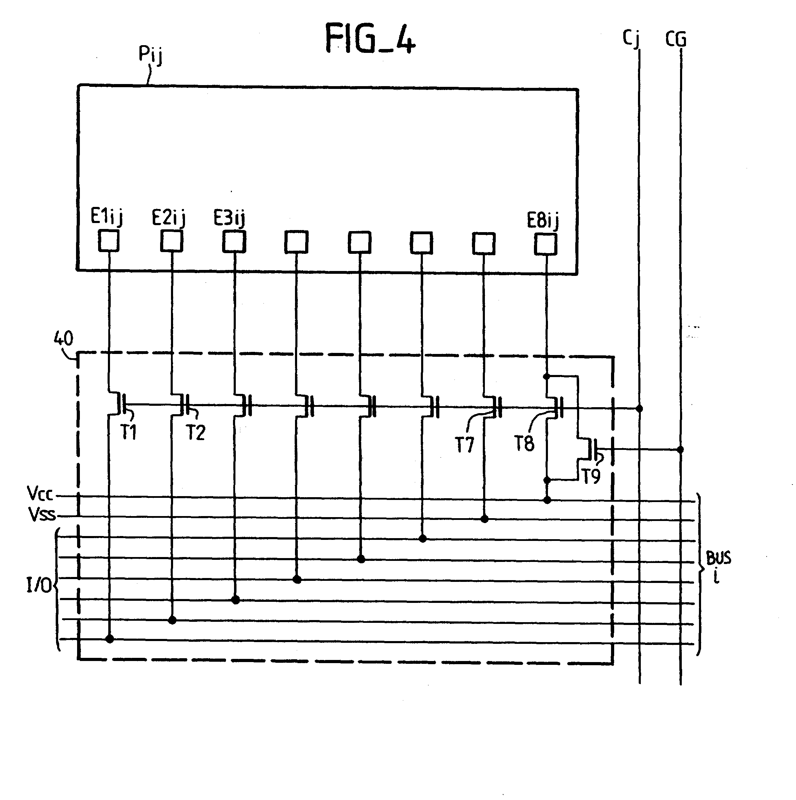

Sur la figure 3, on voit que le démultiplexeur 30 comporte de préférence huit entrées/sorties E1 à E8 de signaux à démultiplexer, c'est-à-dire en principe autant d'entrées/sorties de signaux qu'il y a de plots de contact sur les puces à tester. Ces entrées de signaux peuvent inclure les tensions d'alimentation Vcc et Vss à appliquer aux puces, les signaux d'horloge, etc. Les bus pourraient comporter un nombre de conducteurs plus petit que le nombre de plots de contacts des puces dans les cas où tous les plots ne seraient pas nécessaires pour le test. Les entrées de signaux à démultiplexer sont reliées chacune à un plot respectif de contact 28 de la zone de circuit de test 24.

Le démultiplexeur 30 comporte autant de groupes de sorties S1, S2, ... SN qu'il y a de lignes de puces; par exemple il y a N = 100 groupes de sorties reliés respectivement à N = 100 bus de conducteurs. Et chaque groupe de sorties comprend P = 8 sorties, chaque bus ayant 8 fils. Ces bus partent du démultiplexeur et s'étendent entre les lignes de puces en longeant les puces de chaque ligne, le long des lignes de découpe ultérieure de la tranche.

Le démultiplexeur 30 comporte également des entrées de commande C1, C2,... , en nombre suffisant pour pouvoir contrôler le fonctionnement du démultiplexeur, et en particulier pour pouvoir donner un ordre de sélection d'un bus parmi N. Ces entrées sont reliées à des plots de contact 28 de la zone 24 et elles reçoivent de l'appareil de test notamment une adresse de ligne de puce à tester. Par ces entrées, l'appareil de test peut donc sélectionner un bus de sortie parmi N pour le relier aux entrées/sorties E1 à E8, c'est-à-dire pour le relier à l'appareil de test.

Le décodeur de colonne 32 a également des entrées de commande B1, B2,... reliées à des plots de contact 28, en nombre suffisant pour permettre la sélection d'une colonne parmi les M = 50 colonnes possibles, et il a un nombre de sorties D1, D2 .... égal au nombre M de colonnes. Ces sorties sont reliées à des conducteurs qui passent chacun le long d'une ligne de découpe verticale respective de la tranche, pour s'étendre le long d'une colonne de puces respective.

Chacun de ces conducteurs de sortie du décodeur de colonne permet de commander la liaison entre les puces de cette colonne et les bus qui passent à proximité de ces puces.

Pour des raisons qu'on expliquera plus loin, on prévoit aussi une commande générale d'application d'une tension Vcc à toutes les puces à la fois. Cette commande est transmise par l'appareil de test, par exemple à partir d'un plot 28 de la zone de circuit de test. Ce plot est relié à un conducteur de commande général CG qui se divise en M conducteurs de colonne permettant de contrôler l'application de l'alimentation Vcc aux puces indépendamment de l'état actif ou passif des bus.

La figure 4 représente la connexion locale entre une puce et un bus passant dans une zone de découpe à proximité de cette puce.

Un circuit de connexion 40 est prévu localement à proximité de chaque puce (il pourrait même faire partie de la puce). Ce circuit est commandé principalement par le conducteur de colonne Cj issu du décodeur 32 et correspondant à la colonne j. Le conducteur Cj commande la liaison entre le bus BUSi, correspondant à la rangée i, et une puce Pij située au croisement de la rangée i et de la colonne j. Plus précisément, le conducteur Cj commande la liaison entre les différents conducteurs du bus BUSi et chacun des plots de contact E1ij, E2ij, ...E8ij, de la puce. Huit transistors T1 à T8 commandés par le conducteur Cj ont été représentés pour indiquer cette connexion locale entre la puce et le bus. Le transistor T7 qui permet la connexion à Vss peut être remplacé par un court-circuit si on accepte que Vss soit appliqué systématiquement à toutes les puces ou au moins à toutes les puces d'une même colonne.

Toutes les puces de la colonne j sont connectées aux bus respectifs qui passent à côté d'elles. Mais un seul bus est actif, c'est-à-dire sélectionné par le multiplexeur. Les autres sont en haute impédance (à l'exception des conducteurs Vcc et Vss des bus). Une seule puce est donc sélectionnée pour être testée.

Un neuvième transistor T9 a été représenté pour commander séparément (indépendamment de T8) la connexion entre le plot E8ij (plot destiné à recevoir l'alimentation Vcc) et le huitième conducteur du bus, c'est-à-dire celui qui amène Vcc. Ce transistor T9 est commandé par le conducteur CG.

Il en résulte qu'il y a deux manières d'alimenter la puce :
- soit le conducteur CG est inactif; seule la puce Pij reliée au bus BUSi sélectionné par le démultiplexeur 30 et connectée à ce bus par le conducteur de colonne correspondant Cj sera alimentée;
- soit le conducteur CG est actif, et alors toutes les puces de la rangée sélectionnée par le démultiplexeur sont alimentées; on peut d'ailleurs prévoir que toutes les puces de la tranche sont alimentées, mais alors, avec le circuit représenté à la figure 4, cela suppose que Vcc est transmis systématiquement par tous les bus (même non sélectionnés) lorsque CG est actif.

Cette commande supplémentaire d'alimentation des puces par le bus CG permet notamment d'effectuer en même temps pour toutes les puces les tâches qui sont parallélisables et qui ne nécessitent pas l'application aux puces de signaux autres que l'alimentation.

Dans l'exemple de test de mémoire donné précédemment, l'exécution de la programmation (tâche B) est parallélisable et sera effectuée en utilisant la commande CG.

Les puces défectueuses peuvent être repérées par leur adresse en ligne et en colonne. Elles peuvent être marquées par encrage après la fin du test. Elles peuvent aussi être marquées au moment de la détection d'un défaut, mais alors de préférence par des moyens électriques, tels que l'application d'une tension de claquage électrique à des fusibles disposés à la surface de la puce; ces fusibles sont disposés de telle manière que l'aspect optique de la puce soit suffisamment changé par le claquage pour que la puce puisse être repérée comme une puce mauvaise du seul fait de son changement d'aspect (détectable par un opérateur humain ou par un détecteur optique approprié). Un réseau de fusibles occupant une large surface de la puce peut convenir. Il faut alors prévoir une commande de claquage de ces fusibles à partir de l'appareil de test. Un conducteur supplémentaire dans les bus de test peut être nécessaire.

Lorsque la tranche sera découpée en puces individuelles, les connecteurs locaux 40 n'interviendront plus.

Pour la réalisation pratique des circuits spécifiques de test, on peut prévoir une réalisation en technique classique de circuit intégré, les conducteurs des bus et les autres conducteurs de colonne étant réalisés par le même niveau de métallisation qui sert à faire les plots de contact des puces.

Dans les circuits intégrés dans lesquels on prévoit que la puce est entièrement entourée par une barrière de protection contre les infiltrations d'humidité, le mieux sera d'interrompre localement cette barrière pour laisser le passage à des conducteurs de liaison entre la puce et le connecteur 40. L'interruption de la barrière pourra être en forme de chicane pour détériorer le moins possible l'efficacité de la barrière. Mais on pourrait aussi prévoir que les liaisons entre la puce et le connecteur local se font par un niveau supplémentaire de métallisation, selon des technologies qui n'ont alors plus besoin d'être très fines : par exemple un dépôt et une gravure de polymère conducteur peuvent permettre de faire ces connexions qui ne servent qu'au moment du test. Le polymère conducteur est ensuite éliminé avant la découpe de la tranche.

## Revendications

1. Tranche de circuit intégré (20) destinée à être découpée en puces individuelles (22), comprenant à cet effet des zones principales comportant chacune un circuit intégré respectif qui forme ladite puce, les zones principales étant séparées les unes des autres par des zones de découpe le long desquelles seront effectuées les découpes entre puces individuelles, la tranche comportant un démultiplexeur (30) pour sélectionner et tester les puces et des plots de contact (28) situés dans une zone de circuit de test située en dehors des zones principales, le démultiplexeur ayant des entrées de signaux de test (El à E8) et des entrées de commande (C1, C2, ...) reliées aux plots de contact et ayant des sorties (S1 à Sn) reliées à des bus de conducteurs qui passent le long des zones de découpe entre puces et qui peuvent être reliés aux circuits intégrés des zones principales, caractérisée en ce qu'elle comporte des moyens (CG,T9) pour relier simultanément un plot de contact de chaque puce, destiné à recevoir une tension d'alimentation, à un conducteur de la tension d'alimentation, indépendamment de la sélection des puces par le démultiplexeur pour permettre de tester simultanément toutes les puces avec certaines séquences de test qui ne nécessitent pas l'application aux puces de signaux autres qu'une tension d'alimentation.

2. Tranche selon la revendication 1, caractérisée en ce qu'elle comporte N rangées de puces, N bus de conducteurs passant le long de ces rangées, un connecteur local (40) pour relier une puce déterminée à un bus qui passe à côté de cette puce, des conducteurs de colonne, passant entre des colonnes de puces, chaque conducteur de colonne permettant de commander simultanément tous les connecteurs correspondant aux puces de cette colonne, et un décodeur de colonne (32) ayant des entrées reliées à des plots de contact de la zone de circuit de test et des sorties reliées aux conducteurs de colonne.

3. Tranche selon la revendication 2, caractérisée en ce que le connecteur local (40) est situé à proximité de la puce à laquelle il est associé, et en ce qu'il est relié à des plots de contact de cette puce.

4. Procédé de test d'une tranche de circuit intégré selon la revendication 1, avant découpe de la tranche (20) en puces individuelles (22), comprenant les opérations consistant à appliquer les pointes de test d'un appareil de test sur les plots de contact (28) pour permettre la communication entre une puce ou un groupe de puces déterminées et l'appareil de test, ceci en fonction de signaux de sélection de puce appliqués par l'appareil de test aux entrées de commande du démultiplexeur, caractérisé en ce que l'appareil de test applique des signaux de test successivement aux différentes puces, et en ce que certaines séquences de test ne nécessitant pas l'application aux puces de signaux autres qu'une tension d'alimentation, sont effectuées simultanément pour plusieurs puces à la fois en utilisant les moyens (CG,T9) pour relier simultanément un plot de contact de chaque puce à un conducteur de la tension d'alimentation.

## Patentansprüche

1. Wafer (20) für integrierte Schaltungen, der dazu vorgesehen ist, in einzelne Chips (22) zerteilt zu werden, die hierzu Hauptzonen aufweisen, die jeweils eine entsprechende integrierte Schaltung, die den Chip bildet, enthalten, wobei die Hauptzonen voneinander durch Zerteilungszonen getrennt sind, längs derer die Zerteilungen zwischen den einzelnen Chips vorgenommen werden, wobei der Wafer einen Demultiplexierer (30) zum Auswählen und Prüfen der Chips sowie Kontaktanschlußflächen (28) enthält, die sich in einer Prüfschaltungszone befinden, die sich außerhalb der Hauptzonen befindet, wobei der Demultiplexierer Prüfsignaleingänge (El bis E8) und Steuereingänge (C1, C2, ...), die mit den Kontaktanschlußflächen verbunden sind, sowie Ausgänge (S1 bis Sn) enthält, die mit Leiterbussen verbunden sind, die längs der Zerteilungszonen zwischen den Chips verlaufen und die mit den integrierten Schaltungen der Hauptzonen verbunden werden können, dadurch gekennzeichnet, daß er Mittel (CG, D9) enthält, um gleichzeitig eine Kontaktanschlußfläche jedes Chips, die dazu vorgesehen ist, eine Versorgungsspannung zu empfangen, durch den Demultiplexierer unabhängig von der Wahl der Chips mit einem Versorgungsspannungsleiter zu verbinden, um die gleichzeitige Prüfung sämtlicher Chips mit bestimmten Prüffolgen zu ermöglichen, welche nicht erfordern, andere Signale als die Versorgungsspannungssignale an die Chips anzulegen.

2. Wafer nach Anspruch 1, dadurch gekennzeichnet, daß er N Zeilen von Chips, N Leiterbusse, die längs dieser Zeilen verlaufen, einen lokalen Verbinder (40) zum Verbinden eines bestimmten Chips mit einem Bus, der an der Seite dieses Chips verläuft, Spaltenleiter, die zwischen den Spalten von Chips verlaufen, wobei jeder Spaltenleiter die gleichzeitige Steuerung sämtlicher Verbinder ermöglicht, die den Chips dieser Spalte entsprechen, sowie einen Spaltendecodierer (32) enthält, der Eingänge, die mit den Kontaktanschlußflächen der Prüfschaltungszone verbunden sind, sowie Ausgänge besitzt, die mit den Spaltenleitern verbunden sind.

3. Wafer nach Anspruch 2, dadurch gekennzeichnet, daß sich der lokale Verbinder (40) in der Nähe des Chips befindet, dem er zugeordnet ist, und daß er mit den Kontaktanschlußflächen dieses Chips verbunden ist.

4. Verfahren zum Prüfen eines Wafers für integrierte Schaltungen nach Anspruch 1 vor dem Zerteilen des Wafers (20) in einzelne Chips (22), enthaltend die Operationen, die darin bestehen, die Prüfspitzen eines Prüfgeräts an die Kontaktanschlußflächen (28) anzulegen, um die Kommunikation zwischen einem bestimmten Chip oder einer Gruppe von bestimmten Chips und dem Prüfgerät in Abhängigkeit von Chipwählsignalen, die vom Prüfgerät an die Steuereingänge des Demultiplexierers angelegt werden, zu ermöglichen, dadurch gekennzeichnet, daß das Prüfgerät an die verschiedenen Chips nacheinander Prüfsignale anlegt und daß bestimmte Prüffolgen, die nicht erfordern, daß an die Chips andere Signale als eine Spannungsversorgung angelegt werden, gleichzeitig für mehrere Chips ausgeführt werden, wobei Mittel (CG, D9) verwendet werden, um gleichzeitig eine Kontaktanschlußfläche jedes Chips mit einem Versorgungsspannungsleiter zu verbinden.

## Claims

1. Integrated-circuit wafer (20) designed to be cut into individual chips (22), comprising for this purpose main areas each having a respective integrated circuit which forms the said chip, the main areas being separated from each other by cut-out areas along which the cuts will be made between individual chips, the wafer having a demultiplexer (30) for selecting and testing the chips and contact pins (28) situated in a test circuit area situated outside the main areas, the demultiplexer having test signal inputs (E1 to E8) and control inputs (C1, C2, ...) connected to the contact pins and having outputs (S1 to Sn) connected to conductor buses which pass along the cut-out areas between chips and which can be connected to the integrated circuits of the main areas, characterised in that it includes means (CG, T9) for simultaneously connecting a contact pin on each chip, designed to receive a supply voltage, to a conductor for the supply voltage, independently of the selection of the chips by the demultiplexer, to enable a test to be carried out simultaneously on all the chips with certain test sequences which do not require the application to the chips of any signals other than a supply voltage.

2. Wafer according to Claim 1, characterised in that it has N rows of chips, N conductor buses passing along these rows, a local connector (40) for connecting a given chip to a bus which passes alongside this chip, column conductors, passing between columns of chips, each column conductor making it possible to control simultaneously all the connectors corresponding to the chips in this column, and a column decoder (32) having inputs connected to contact pins of the test circuit area and other outputs connected to the common conductors.

3. Wafer according to Claim 2, characterised in that the local connector (40) is situated close to the chip with which it is associated, and in that it is connected to contact pins on this chip.

4. Method of testing an integrated-circuit wafer according to Claim 1, before cutting the wafer (20) into individual chips (22), comprising the operations consisting of applying the test probes of test apparatus to the contact pins (28) so as to allow communication between a chip or a group of given chips and the test apparatus, as a function of chip selection signals applied by the test apparatus to the demultiplexer control inputs, characterised in that the test apparatus applies test signals successively to the different chips, and in that certain test sequences which do not require the application to the chips of signals other than a supply voltage are performed simultaneously for several chips at the same time using the means (CG, T9) for simultaneously connecting a contact pin on each chip to a conductor for the supply voltage.
